Europäisches Patentamt

European Patent Office

Office européen des brevets

(11) Publication number: **0 065 463**
**B1**

# EUROPEAN PATENT SPECIFICATION

(45) Date of publication of patent specification: **17.12.86**

(21) Application number: **82400874.2**

(22) Date of filing: **11.05.82**

(51) Int. Cl.⁴: **H 01 L 21/31,** H 01 L 29/72, H 01 L 29/10

(54) **Self-aligned lateral transistor and method of manufacture thereof.**

(30) Priority: **11.05.81 US 262568**
**11.05.81 US 262577**

(43) Date of publication of application:
**24.11.82 Bulletin 82/47**

(45) Publication of the grant of the patent:
**17.12.86 Bulletin 86/51**

(84) Designated Contracting States:
**DE FR GB IT NL**

(56) References cited:
**EP-A-0 002 191**
**EP-A-0 005 728**
**EP-A-0 007 923**
**US-A-4 115 797**
**US-A-4 168 999**

**IBM TECHNICAL DISCLOSURE BULLETIN, vol. 23, no. 7A, december 1980, pages 2819-2821, New York, US M. BRISKA et al.: "High precision basewidth control for vertical NPN and lateral PNP transistors"**

(73) Proprietor: **FAIRCHILD CAMERA & INSTRUMENT CORPORATION**
**464 Ellis Street**
**Mountain View California 94042 (US)**

(72) Inventor: **Shideler, Jay A.**
**11 Murphy Place**
**San Mateo California 94402 (US)**
Inventor: **Berry, Robert L.**
**20192 Northcove Square**
**Cupertino California 95014 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

(56) References cited:
**JOURNAL OF APPLIED PHYSICS, vol. 50, no. 1, January 1979, pages 193-201, New York, US T. HIRAO et al.: "The concentration profiles of projectiles and recoiled nitrogen in Si after ion implantation through Si3N4 films"**

Courier Press, Leamington Spa, England.

## Description

### Background of the invention

### 1. Field of the invention

This invention relates to a method for forming a pair of doped regions according to the pre-characterising part of claim 1. Such a method is known from US—A—4168999. Furthermore the invention relates to a lateral transistor according to the pre-characterising part of claim 18. Such a transistor is known from US—A—4066473.

### 2. Description of the prior art

Lateral bipolar transistors are of substantial importance in semiconductor devices. Unlike vertical bipolar transistors in which base width can be accurately regulated by controlling vertical diffusions, lateral transistors pose greater difficulties in producing bases which are sufficiently narrow to achieve high gain and whose dimensions are accurately controllable and reproducible.

Within the prior art, R. Schinella et al. disclose the structure and method for making a lateral transistor using two diffusions through a single mask opening in U.S. Patent 3,873,989, "Double-Diffused Lateral Transistor Structure", U.S. Patent 3,919,005, "Method for Fabricating Double-Diffused, Lateral Transistor", and U.S. Patent 3,945,857, "Method for Fabricating Double-Diffused, Lateral Transistors." A lateral transistor made according to the foregoing patents typically has a minimum base width of approximately 0.5 to 1 micron with an impurity gradient in the horizontal direction across the base; this impurity gradient is undesirable in some applications.

D. O'Brien discloses a method for fabricating a singly-diffused lateral transistor in U.S. Patent 4,066,473, "Method of Fabricating High-Gain Transistors." The base width of the lateral transistor manufactured according to this O'Brien patent is typically 1—3 microns using current masking technology. There is substantially no horizontal impurity gradient across the base.

Bipolar transistors of both the lateral and vertical type often utilize oxide-isolation techniques such as those disclosed by D. Peltzer in U.S. Patent 3,648,125, "Method of Fabricating Integrated Circuits with Oxidized Isolation and the Resulting Structure," to demarcate the active semiconductor regions. Such oxide-isolation techniques are further described by Peltzer in "Isoplanar Processing," *1972 Wescon Technical Papers,* presented at Western Electronic Show and Convention, 19—22 September 1972, Session 19, Section 19/2 pages 1—4. D. O'Brien discloses the use of an anti-version region with oxide isolation for making complementary lateral and vertical transistors in U.S. Patent 3,962,717, "Oxide Isolated Integrated Injection Logic with Selective Guard Ring," and U.S. Patent 3,993,513, "Combined Method for Fabricating Oxide-Isolated Vertical Bipolar Transistors and Complementary Oxide-Isolated Lateral Bipolar Transistors and the Resulting Structures."

In fabricating integrated circuit structures such as those having complementary lateral and vertical bipolar transistors, many of the semiconductor regions may be formed by ion implantation techniques. One of the perennial problems in ion implantation is the prevention of ions in the ion beam from entering semiconductor regions where implantation is not desired. J. Stephen in "The Contribution of Ion Implantation to Silicon Device Technology," Proceedings of the Technical Program, International Microelectronics Conference, Anaheim, California, 11—13 February and 17—19 June 1975, pages 88—97, suggests that silicon nitride might be used as a mask to prevent undesired ion implantation in semiconductor circuits.

### Summary of the invention

It is a general object of the present invention to provide a self-aligned lateral bipolar transistor in a semiconductor body such as an epitaxial layer on the substrate of a silicon semiconductor wafer or simply such a substrate itself.

One aspect of the invention includes a method for forming a pair of doped region according to claim 1.

A preferred embodiment of this aspect of the invention consists in that the above defined method is applied for manufacturing a transistor, having a base, an emitter and a collector, which method is characterized in that the second conductivity type is opposite to the first conductivity type and that the emitter comprises one of the second doped region and the completed first doped region, and the collector comprises the other of the second doped region and the completed first doped region.

A further aspect of the invention is attained by a lateral transistor according to claim 18.

### Brief description of the drawings

Figs. 1a—1v and 1k' are cross-sectional views of a semiconductor wafer illustrating steps for fabricating a lateral bipolar transistor and a complementary vertical bipolar transistor.

Figs. 2a—2c are a silicon implant depth graph, an expanded cross-sectional view of a part of Fig. 1k, and a corresponding concentration profile, respectively, useful in understanding the ion-implantation protecting capability of silicon nitride.

Figs. 3l, 3m, 3o, and 3s are expanded cross-sectional views of part of Figs. 1l, 1m, 1o, and 1s, respectively.

Fig. 4 is a graph for etchback distance as a function of time.

Like reference symbols are employed in the drawings to represent the same item or items in the drawings and in the description of the preferred embodiments.

### Description of the preferred embodiments

In the following description. boron is generally used as the P-type impurity (or dopant) for creating the various regions of P-type conductivity in or on a semiconductor wafer. Antimony and phosphorous are employed selectively as the complementary N-type impurities for creating the N-type regions. Other appropriate impurities may be utilized in place of the foregoing dopants.

Conventional photomasking, cleaning, and annealing techniques, which are well known in the prior art, are employed in fabricating a lateral bipolar transistor and a complementary vertical bipolar transistor. Accordingly, no references are made to the steps involved in creating and removing a mask of photoresist or to the cleaning and annealing steps.

Directional adjectives such as "upper," "lower," "top," and "bottom" are used solely for describing the invention with respect to a semiconductor wafer lying flat and substantially parallel to the ground as viewed from the side. "Lateral" or "horizontal" refers to a direction generally along a direction parallel to the plane in which (the substantially flat bottom surface of) the wafer lies, while "vertical" refers to a direction generally orthogonal to the plane of the wafer.

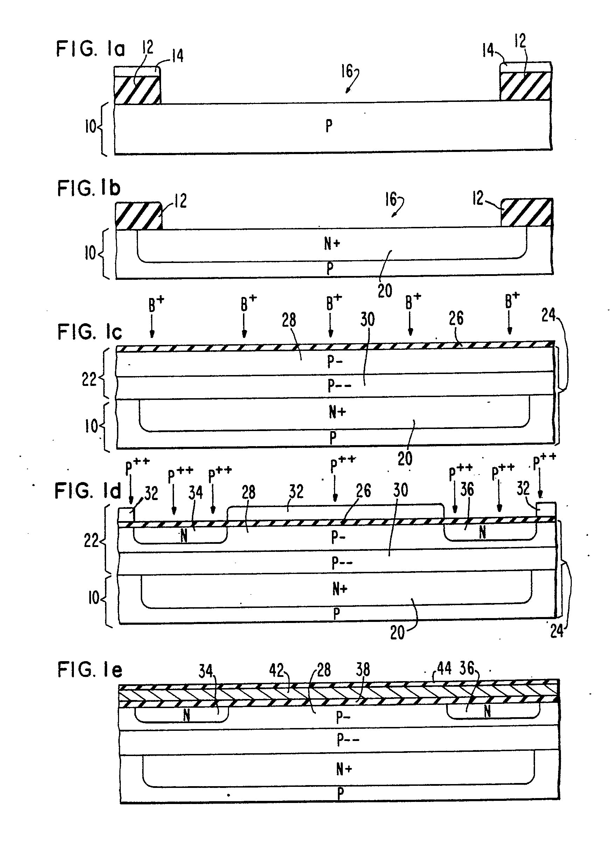

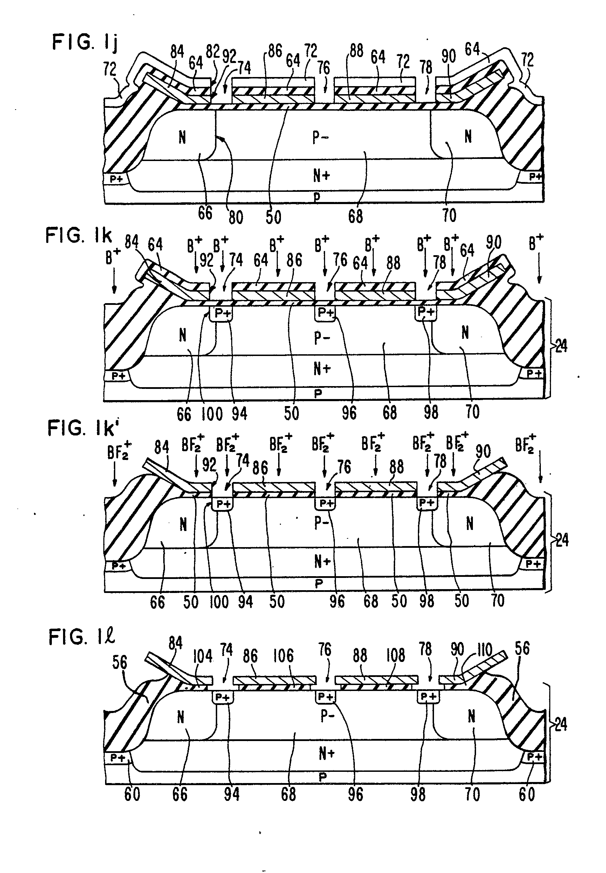

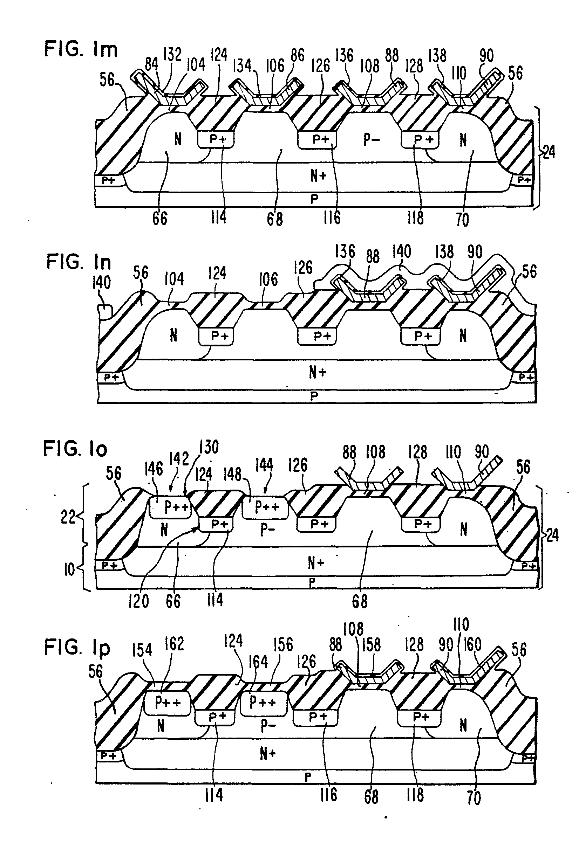

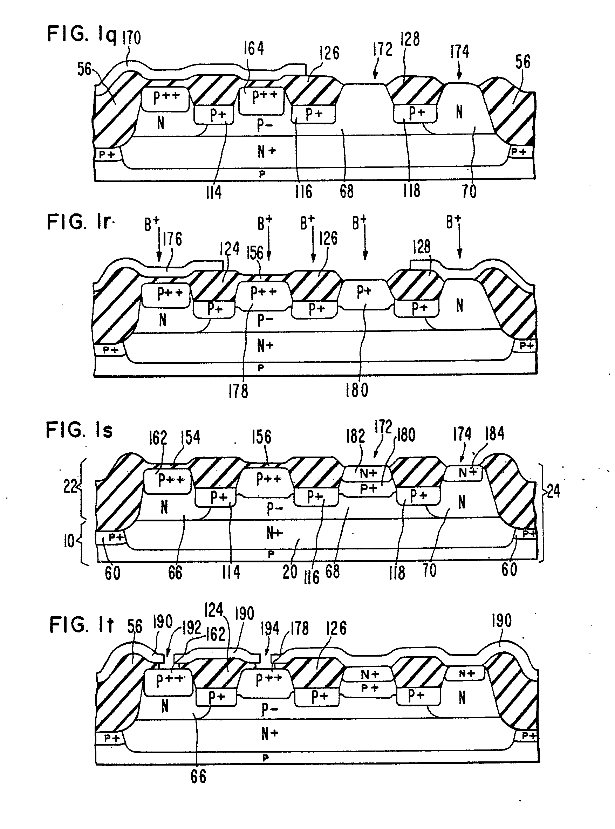

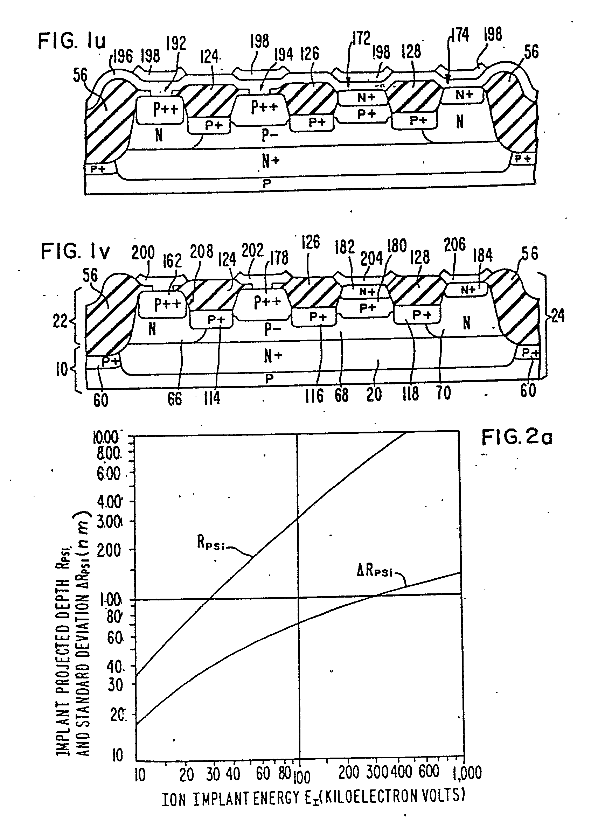

Referring to the drawings, Figs. 1a—1v and 1k' illustrate steps in manufacturing the lateral and vertical transistors using a substrate 10 of a semiconductor wafer. Substrate 10 is P-type monocrystalline silicon having a resistivity of 1—3 ohm-centimeters. Initially, an electrically insulating layer 12 of silicon dioxide is on the top surface of substrate 10 as shown in Fig. 1a. Oxide layer 12 has a thickness of approximately 800 nm (8,000 angstroms).

A photoresist mask 14 is formed on the top surface of oxide layer 12. A hole 16 is etched through oxide layer 12 by exposing it through an opening in mask 14 for about 10 minutes (which equals the time needed to clear the exposed silicon dioxide plus about 1 minute) to a buffered etchant consisting of 1 part of electronic-grade hydrofluoric acid (49 weight percent HF) and 6 parts of a solution of 40 weight percent ammonium fluoride in water (hereafter "buffered hydrofluoric acid"). The buffered hydrofluoric acid substantially does not attack the underlying (doped) silicon.

After removing mask 14, an N-type impurity, antimony from an $Sb_2O_3$ source, is diffused into the portion of substrate 10 exposed by hole 16 at a temperature of 1,240°C to form buried N+ region 20 as depicted in Fig. 1b. N+ region 20 has a sheet resistance of approximately 30—35 ohms/square and a depth (or thickness) of about 2,500 nm (25,000 angstroms). (The wafer is then exposed to dry oxygen for 15 minutes at a temperature of 1240°C to grow a layer of silicon dioxide about 100 nm (1000 angstroms) in thickness at the portion of the wafer surface exposed by hole 16. Inasmuch as the depression of about 50 nm (500 angstroms) depth remaining after removal of this oxide layer is only employed for mask registration, neither this oxide layer nor this depression are illustrated in the drawings.) The remaining portions of oxide layer 12 (as well as the oxide layer in hole 16 at the wafer surface) are stripped away by submerging the wafer in electronic-grade hydrofluoric acid.

A P−− epitaxial layer 22 of P-type silicon is grown from dichlorosilane according to conventional techniques on the top surface of substrate 10 including over N+ region 20 as shown in Fig. 1c. Epitaxial layer 22 has a thickness of 1400—1600 nm (14,000—16,000 angstroms) and a resistivity greater than 10 ohm-centimeters. In combination, substrate 10 and epitaxial layer 22 constitute a composite body 24 of semiconductor material. The top surface of epitaxial layer 22 is oxidized by exposing it for 10 minutes to dry oxygen at a temperature of 1,000°C to grow an electrically insulating layer 26 of silicon dioxide having a thickness of 20—40 nm (200—400 angstroms). Oxide layer 26 serves to protect substrate 10 from contamination during subsequent ion implantations.

A P-type dopant, boron in the form of $B^+$, is ion implanted through insulation layer 26 into epitaxial layer 22 at a dosage of $2 \times 10^{12}$ ions/centimeter$^2$ at an energy level of 200 kiloelectron volts to create a P− layer 28. The direction of implantation is generally orthogonal to the plane of the wafer—i.e., no more than 7 degrees from the vertical. The sheet resistance of P− layer 28 is about 9000 ohms/square. The remaining portion of epitaxial layer 22 is illustrated as P−− layer 30.

As illustrated in Fig. 1d, a photoresist mask 32 is formed on the top surface of oxide layer 26. An N-type dopant, phosphorus in the form of $P^{++}$, is implanted through the portions of oxide layer 26 exposed by a pair of open regions in mask 32 at a dosage of $5 \times 10^{13}$ ions/centimeter$^2$ at an energy level of 400 kiloelectron volts to form N regions 34 and 36 spaced apart from each other in P− layer 28 generally above N+ region 20. Again, the direction of implantation is generally orthogonal to the plane of the wafer—i.e., 7 degrees off vertical at most. N regions 34 and 36 have a sheet resistance of about 130—140 ohms/square. Alternatively, regions 34 and 36 may be created by implanting phosphorous in the form of $P^+$.

After stripping away mask 32, oxide layer 26 is etched away by submerging the wafer for 30 seconds in buffered hydrofluoric acid. The top surface of P− layer 28 is oxidized by exposing it to dry oxygen for 10 minutes at 1,000°C to create a new protective electrically insulating layer 38 of silicon dioxide as depicted in Fig. 1e. Insulation layer 38 has a thickness of 20—40 nm (200—400 angstroms).

A protective electrically insulating layer 42 of silicon nitride ($Si_3N_4$) is deposited on the top surface of oxide layer 38. Nitride layer 42 has a thickness of 150—180 nm (1,500—1,800 angstroms). The top surface of nitride layer 42 is oxidized by exposing it to steam at a temperature of 1,000°C for 60 minutes to form a protective electrically insulating layer 44 of silicon dioxide having a thickness of approximately 5 nm (50 angstroms).

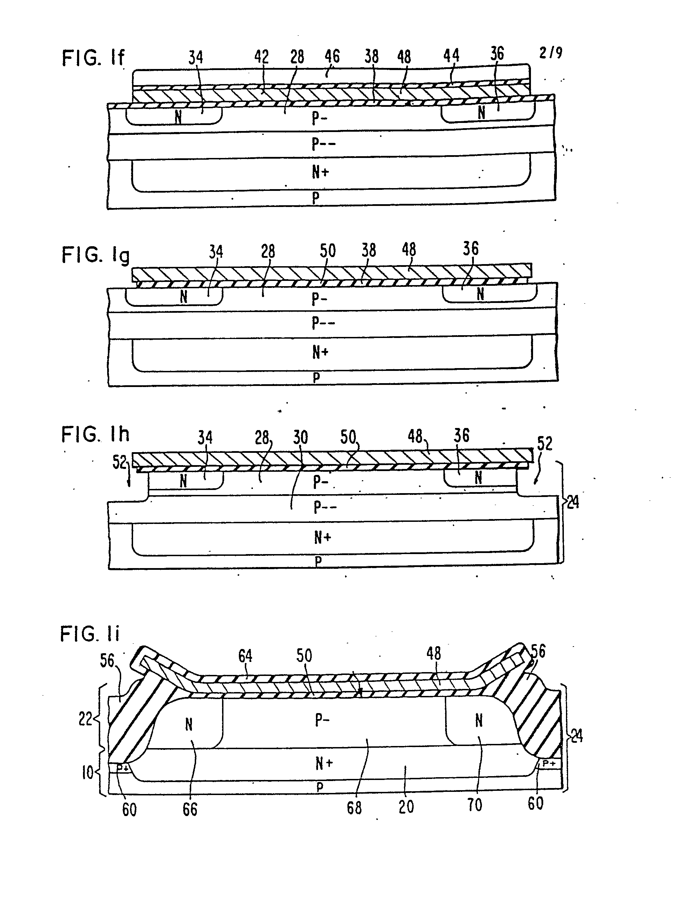

As shown in Fig. 1f, a photoresist mask 46 is formed on the top surface of oxide layer 44. Mask 46 overlies portions of N regions 34 and 36 as well as the portion of P− region 28 between N regions 34 and 36. The portions of insulation layer 44 not protected by mask 46 are removed by etching for 1 minute with buffered hydrofluoric acid. The underlying portions of silicon-nitride layer 42 are removed by etching with boiling electronic-grade phosphoric acid (85—86 weight percent $H_3PO_4$) (hereafter "boiling phosphoric acid") for approximately 60 minutes. Item 48 indicates the portion of nitride layer 42 remaining after these steps.

After removing mask 46, the top surface of the wafer is exposed for 1 minute to buffered hydrofluoric acid. The buffered hydrofluoric acid substantially does not attack silicon nitride. As a consequence, the portions of oxide layer 38 not overlaid by nitride layer 48 are etched away as illustrated in Fig. 1g. Item 50 indicates the remaining portion of oxide layer 38. The remaining portion of oxide layer 44 overlying nitride layer 48 is also removed during this step.

Next, an annular groove 52 is formed below the areas where oxide layer 38 has been removed by exposing the top surface of the wafer to an iodine buffered etchant formed in the proportions of 27.5 grams of iodine, 5,000 milliliters of electronic-grade acetic acid (99.7 weight percent $CH_3COOH$), 200 milliliters of electronic-grade hydrofluoric acid, and 2,500 milliliters of electronic-grade nitric acid (69—71 weight percent $HNO_3$). Groove 52 extends all the way through P− layer 28 and partially into P−− layer 30 as depicted in Fig. 1h. Groove 52 also extends back under nitride layer 48 and into parts of N regions 34 and 36.

According to techniques described in U.S. Patent 3,962,717, cited above and specifically incorporated by reference herein, a P-type impurity, boron from a $BBr_3$ source, is deposited on the surface area forming groove 52 and then driven to a shallow depth into the wafer material adjacent to groove 52 by a predeposition process to form a P+ antiinversion guard ring around groove 52.

As illustrated in Fig. 1i, an annular electrically insulating oxide-isolation region 56 is formed in groove 52 according to techniques generally described in U.S. Patent 3,648,125, cited above and specifically incorporated by reference herein. In particular, the silicon adjacent to groove 52 is oxidized by exposing it at a temperature of 1,000°C in dry oxygen for 90 minutes and then in steam for 720 minutes.

During this oxide-isolation process, the antiinversion guard ring diffuses downward and sideward ahead of the advancing silicon/silicon-dioxide interface where silicon is being converted into oxide region 56. P+ antiinversion region 60 is the remaining portion of the antiinversion guard ring. In forming oxide-isolation region 56, the ends of nitride layer 48 bend upward away from substrate 10 as silicon dioxide grows under the end portions of nitride layer 48. The top of oxide region 56 is in the shape of a "bird beak" with the tip of the bird beak occurring approximately where the ends of nitride layer 48 bend upward. The oxide-isolation process also causes the top surface of nitride layer 48 to oxidize forming an electrically insulating layer 64 of silicon dioxide which extends over the ends of layer 48 to join with oxide-isolation region 56. Oxide layer 64 has a thickness of about 50—100 nm (500—1000 angstroms). The thickness of nitride layer 48 decreases slightly as a consequence of the formation of oxide layer 64.

The implanted impurities in silicon regions 34, 28, and 36 diffuse generally downward toward N+ region 20 during the oxide-isolation process. As a consequence, N region 34, P− region 28, and N region 36 become N region 66, P− region 68, and N region 70, respectively, which share their lower boundaries with the upper boundary of buried N+ region 20. Since the ion implantations generally follow a Gaussian distribution as a function of depth into the doped silicon, part of the impurities implanted in original N regions 34 and 36 also diffuse upward to reduce the impurity gradient substantially in the vertical direction. The net dopant concentration in N regions 66 and 70 is about $4 \times 10^{17}$ ions/centimeter$^3$, and the net dopant concentration in P− region 68 is about $2 \times 10^{16}$ ions/centimeter$^3$.

A photoresist mask 72 having holes 74, 76, and 78 is formed on the top surface of the wafer as illustrated in Fig. 1j. Hole 74 overlies adjacent portions of N region 66 and P− region 68—i.e., hole 74 overlies the right-hand boundary 80 of N region 66 and extends to the right from the right-hand edge 82 of mask 72. Likewise, hole 78 overlies adjacent portions of regions 68 and 70. Hole 76 overlies region 68 between holes 74 and 78.

The portions of oxide layer 64 exposed by holes 74, 76, and 78 are removed by the etching with buffered hydrofluoric acid for 1 minute. Next, holes 74, 76 and 78 are extended downward through silicon-nitride layer 48 by etching with boiling phosphoric acid for 60 minutes. This leaves silicon-nitride regions 84, 86, 88 and 90 as the remaining portions of nitride layer 48 where region 84 generally lies above N region 66. The well-defined right-hand edge 92 of nitride region 84 is generally vertically aligned with masking edge 82.

After removing mask 72, a P-type dopant, boron in the form of $B^+$, is ion implanted preferably at a dosage of $6 \times 10^{14}$ ions/centimeter$^2$ at an energy of 27 kiloelectron volts through the portions of oxide layer 50 exposed by holes 74, 76, and 78 into the underlying silicon to form P+ regions 94, 96, and 98 as shown in Fig. 1k. P+ region 94 occupies adjacent portions of N region 66 and P− region 68. Likewise P+ region 98 occupies adjacent portions of regions 68 and 70. P+ regions 96 consists solely of a portion of 68. P+ regions 94, 96, and 98 each have a sheet resistance of about 200 ohms/square.

Silicon-nitride regions 84, 86, 88, and 90 in combination with oxide layer 50 and the remaining portions of oxide layer 64 act as protective covering to prevent implantation of singly ionized (or charged) boron into the doped silicon underlying nitride regions 84, 86, 88 and 90. Accordingly, except for a small calculable lateral scattering deviation (which is about 50 nm (500 angstroms) here) and a small off-angle deviation (normally less than 10 nm (100 angstroms)) caused by implanting $B^+$ ions at a direction no greater than 7 degrees from the vertical, the left-hand and right-hand boundaries (or edges) of P+ regions 94, 96, and 98 are all substantially aligned with the corresponding well-defined end edges of nitride regions 84, 86, 88 and 90. In particular, right-hand edge 92 of nitride region 84 is substantially in vertical alignment with the left-hand boundary 100 of P+ region 94.

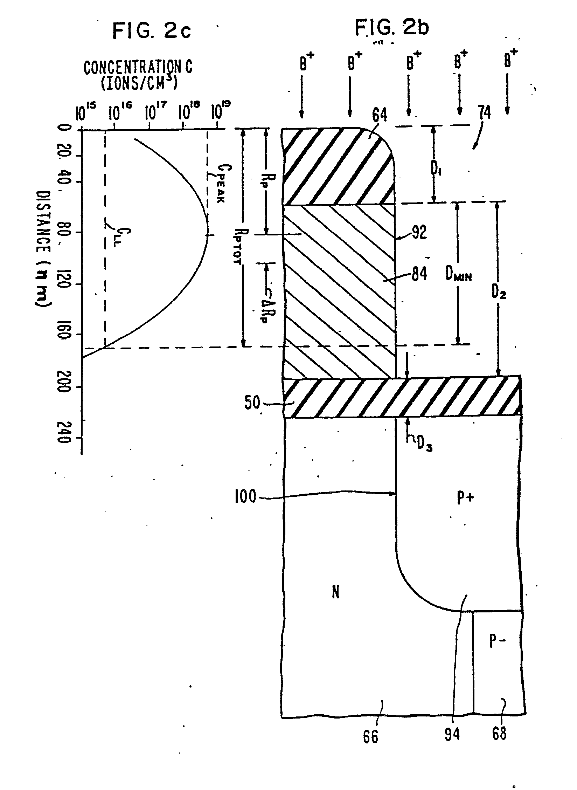

The ability of nitride regions 84, 86, 88, and 90 to act as protective covering for stopping impinging $B^+$ ions and thereby preventing them from entering protected silicon regions is demonstrated with the assistance of Figs. 2a, 2b and 2c.

Referring to Fig. 2a which is derived from Gibbons et al., "Projected Range Statistics" (2d ed., Halstead Press) 1975, it illustrates projected implanted depth (or range) $R_{PSi}$ for $B^+$ ions into silicon as a function of implant energy $E_I$. Impant depth $R_{PSi}$ represents the point at which the $B^+$ ions in silicon are at the maximum implant concentration. The distribution of $B^+$ ions in silicon is Gaussion to a first-order approximation in the vicinity of the maximum implant concentration and is represented in Fig. 2a by standard deviation $\Delta R_{PSi}$ measured in the direction of implant depth $R_{PSi}$. For semiconductor applications such as the present one, implant energy $E_I$ is normally in the range of 10—400 kiloelectron volts.

Silicon is defined to have a "stopping power" of 1.00 (unity) for $B^+$ ions impinging at given implant energy $E_I$. The stopping powers of silicon nitride and silicon dioxide for $B^+$ ions impinging at energy $E_I$ are defined relative to the stopping power of silicon. On this scale, silicon nitride has a stopping power $f_{SN}$ of about 1.25. That is, $B^+$ ions impinging at energy $E_I$ penetrate only about $1/f_{SN}$ (about four-fifths) as far into silicon nitride as into silicon. Silicon dioxide has a stopping power of $f_{ox}$ of about 1.02. Consequently, silicon nitride has nearly 25 percent more stopping power than silicon dioxide.

Turning to Fig. 2b, it shows an expanded view of a part of Fig. 1k centering around hole 74, oxide layer 64, and nitride region 84. The vertical distances in Fig. 2b are drawn to a relative scale closely corresponding to the vertical distances given above and represented by the distance scale of Fig. 2c. Fig. 2c depicts a profile for the concentration C of $B^+$ ions impinging on oxide layer 64 and entering nitride region 84 as a function of the vertical distance (or depth) from the top surface of oxide layer 64.

As shown in Fig. 2c, the distribution of $B^+$ ions in silicon-nitride region 84 is Gaussian to a first-order approximation. The peak concentration $C_{PEAK}$ of $B^+$ ions in nitride region 84 is about

$5 \times 10^{19}$ ions/centimeter$^2$ and occurs at implant depth $R_P$ (which extends across the thickness $D_1$ of oxide layer 64). Implant depth $R_P$ is given approximately by

$$R_P = D_1 + \frac{(R_{PSi} - f_{ox} D_1)}{f_{SN}} \qquad (1)$$

where silicon implant depth $R_{PSi}$ is determined as a function of energy $E_I$ from Fig. 2a.

Beyond implant depth $R_p$, the concentration C drops to a lower level $C_{LL}$ at an effective total implant depth $R_{PTOT}$ beyond which any additional $B^+$ ions have negligible effect. This establishes the minimum thickness $D_{MIN}$ needed for nitride region 84. Adequate protection from $B^+$ ions is normally provided when concentration $C_{LL}$ is about a thousandth (or less) of concentration $C_{PEAK}$. Total implant depth $R_{PTOT}$ is determined from

$$R_{PTOT} = R_p + a\Delta R_p = R_p + \frac{a\Delta R_{PSi}}{f_{SN}} \qquad (2)$$

where $\Delta R_p$ is the standard deviation of $B^+$ ions in silicon nitride, $a$ is a proportionality constant given approximately as $\sqrt{2 \ln (C_{PEAK}/C_{LL})}$ and equal to 3.74 at a concentration ratio $C_{PEAK}/C_{LL}$ of $10^3$, and standard deviation $\Delta R_{PSi}$ is determined as a function of implant energy $E_I$ from Fig. 2a.

Since the total thickness of oxide layer 64 and nitride region 84 exceeds total implant depth $R_{PTOT}$, the thickness $D_2$ of nitride region 84 (or region 86, 88, or 90) thereby exceeds minimum thickness $D_{MIN}$ given by

$$D_{MIN} = \frac{R_{PSi} + a\Delta R_{PSi} - f_{ox} D_1}{f_{SN}} \qquad (3)$$

If oxide layer 64 either is removed or is not formed in the first place, the term involving thickness $D_1$ drops out of Eq. (3) and thickness $D_{Min}$ increases accordingly. For the embodiment described above, thickness $D_2$ exceeds thickness $D_{MIN}$ by about 25 nm (250 angstroms).

Oxide layer 50 also provides protection against undesired $B^+$ implantation. The thickness $D_3$ of insulation layer 50 may likewise be taken into account in Eq. (3).

Eqs. (1)—(3) apply generally to the implantation of ions other than $B^+$ ions. In this case, $R_{PSi}$ and $\Delta R_{PSi}$ are the projected implant depth and corresponding standard deviation, respectively, for the particular ionic species in silicon. Likewise, $f_{SN}$ and $f_{ox}$ are the stopping powers of silicon nitride and silicon dioxide, respectively, for the particular ionic species relative to the stopping power of silicon.

In another embodiment as shown in Fig. 1k', the portions of oxide layer 50 exposed through holes 74, 76, and 78 are removed by submerging the wafer in buffered hydrofluoric acid for 1 minute after mask 72 is removed but before forming P+ regions 94, 96, and 98. The remaining portions of oxide layer 64 are also removed during this etching step. Holes 74, 76, and 78 then extend down to the upper surface of the underlying silicon. P+ regions 94, 96, and 98 are then formed by implanting boron in the form of $BF_2^+$ (singly ionized boron difluoride produced from boron trifluoride) through holes 74, 76, and 78, respectively. Nitride regions 84, 86, 88, and 90 again act as a shield to prevent $BF_2^+$ implantation into other portions of the wafer below oxide layer 50. The implant dosage is again $6 \times 10^{14}$ ions/centimeter$^2$, but the implant energy is about 50—70 kiloelectron volts principally to account for the higher molecular weight of $BF_2^+$ compared to $B^+$.

In contrast to $B^+$ ions which do not detrimentally alter the structure of silicon nitride so as to destroy its resistance to etchants such as buffered hydrofluoric acid, $BF_2^+$ ions do substantially alter the etching resistance of silicon nitride. Subsequent etching with buffered hydrofluoric acid after $BF_2^+$ implanting normally removes a layer of silicon nitride having a thickness on the order of a $BF_2^+$ implant depth. Implanting with $BF_2^+$, however, offers the advantages of utilizing the ion implanting device in a mode which allows much higher dosage rates and a more easily controllable ion beam that with $B^+$. The problem of silicon-nitride degradation through $BF_2^+$ implantation may be alleviated by appropriately increasing the thickness of nitride regions 84, 86, 88, and 90 to allow for subsequent etching(s).

In another alternative, a layer of PVX (vapor deposited silicon dioxide containing about 6 weight percent phosphorous) may be deposited on oxide layer 64 prior to formation of mask 72 so as to provide additional boron implantation protection. This, however, necessitates more processing steps.

In still another alternative, P+ regions 94, 96, and 98 are formed using the structure generally shown in Fig. 1k' by predepositing boron from a BBr$_3$ source or another boron-based dopant gas through holes 74, 76, and 78 to a shallow depth into the underlying doped silicon rather than by implanting $BF_2^+$. Since boron also diffuses laterally during this predeposition, left-hand boundary 100 is slightly further to the left of the location shown in Fig. 1k' but is still accurately determinable. This alternative has the advantage of not causing irreparable lattice damage which may occur with a boron implant at a dosage ranging from $10^{14}$—$10^{16}$ ions/centimeter$^2$.

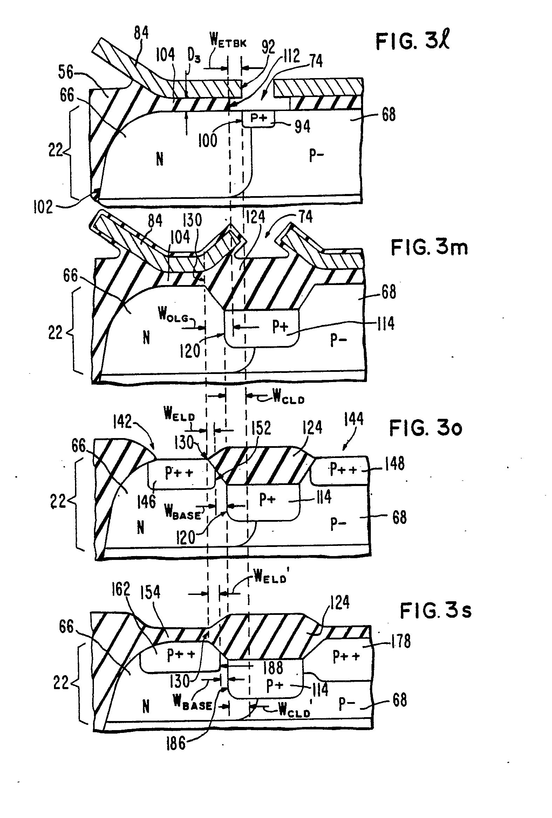

At this point, attention is called to Figs. 3l, 3m, 3o, and 3s which depict expanded views of parts of Figs. 1l, 1m, 1o, and 1s, respectively, centering around regions 66, 84, and 94 and hole 74 to assist further in understanding the steps illustrated by Figs. 1l—1s.

Where $B^+$ ions have been implanted to form P+ regions 94, 96, and 98 in accordance with the procedure described for Fig. 1k, the wafer is submerged in buffered hydrofluoric acid at an etchant temperature $T_{ET}$ of 21°C for a calculated etching time $t_{ET}$ in the range of 7—10 minutes to etch oxide layer 50 through holes 74, 76, and 78. This etching of oxide layer 50 extends back under nitride regions 84, 86, 88, and 90 as shown in Fig. 1l. Etchant temperature $T_{ET}$ is controlled to better than $\pm$ 0.5°C since etching rate is a strong function of temperature $T_{ET}$. The distances of the etchbacks under nitride regions 84, 86, 88, and 90 are precisely regulated by controlling etching time $t_{ET}$. The remaining portions of oxide layer 50 are indicated as oxide portions 104, 106, 108, and 110. Nitride regions 84, 86, 88, and 90 act as protective covering to prevent further etching of insulation portions 104, 106, 108, and 110, respectively, from above.

As shown in Fig. 3l, this etching extends back a distance (or width) $W_{ETBK}$ from right-hand edge 92 of nitride region 84 to the right-hand edge 112 of oxide portion 104.

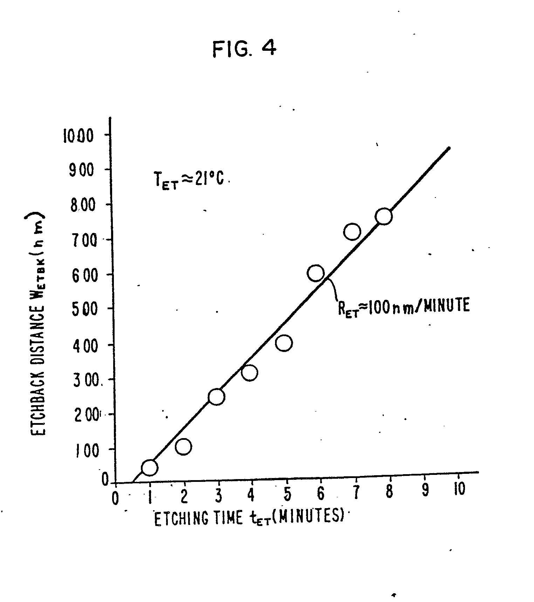

Etchback distance $W_{ETBK}$ substantially increases linearly with etching time $t_{ET}$ at constant etchant temperature $T_{ET}$. Referring to Fig. 4, it shows experimental data taken for etchback distance $W_{ETBK}$ at different etching times $t_{ET}$ for buffered hydrofluoric acid. After a short initial time (around 20—40 seconds) during which the buffered hydrofluoric acid etches down to the surface of the underlying silicon, distance $W_{ETBK}$ subsequently increases nearly linearly with time $t_{ET}$. The etching rate $R_{ET}$, as shown by the straight line through the experimental data, is about 100 nm (1000 angstroms)/minute. This linear relationship holds at least up to an aspect ratio $W_{ETBK}/D_3$ of about forty.

If any of the embodiments involving the implantation of $BF_2^+$ to form P+ regions 94, 96, and 98 is employed, etching time $t_{ET}$ is reduced about 1 minute since the portions of oxide layer 50 directly below holes 74, 76, and 78 have already been removed. The resulting structure is again that shown in Figs. 1l and 3l. Likewise etching time $t_{ET}$ is reduced about 1 minute if P+ regions 94, 96, and 98 are formed by boron predeposition.

The hydrofluoric acid during this etching step also acts on the upper surfaces of oxide-isolation region 56 to substantially decrease the severity of the bird beak.

The wafer (in any of the embodiments) is now exposed at a temperature of 1,000°C to dry oxygen for 30 minutes and then to steam for 120 minutes to drive the P-type impurity in P+ regions 94, 96, and 98 downward and sideward further into the adjacent doped silicon to create P+ regions 114, 116, and 118, respectively, as shown in Fig. 1m. Nitrogen may be used instead of dry oxygen in this step at the risk of some undesired boron autodoping (out diffusion) into N region 66. Each of P+ regions 114, 116, and 118 has a sheet resistance of about 6000 ohms/square.

Referring to Figs. 3l and 3m, the lateral diffusion of the P-type impurity from P+ region 94 is represented as a distance (or width) $W_{CLD}$ from

left-hand side 100 of original P+ region 94 to the new left-hand boundary 120 of P+ region 114.

This step of subjecting the wafer to high-temperature steam causes the portions of the doped silicon exposed through holes 74, 76, and 78 to oxidize and form electrically insulating regions 124, 126, and 128, respectively of silicon dioxide as shown in Fig. 1m. In particular, insulation region 124 grows from N region 66, P+ region 94, and P− region 68 and subsequently consists of adjacent oxidized portions of N region 66 and P+ region 114 and an oxidized portion of P− region 68. Similarly, insulation region 128 grows from N region 70, P+ region 98, and P− region 68. Insulation region 126 grows from P+ region 96 and P− region 68. The thickness (or depth) of oxide regions 124, 126, and 128 is about 400 nm (4,000 angstroms). Each of oxide regions 124, 126, and 128 has left-hand and right-hand edges of tips extending (or encroaching) into the nearest pair of oxide portions 104, 106, 108, and 110 to form a continuous oxide region across the top of the wafer. Nitride regions 84, 86, 88, and 90 act as protective coverings to inhibit oxidation of the doped silicon at places apart from holes 74, 76, and 78.

As indicated in Fig. 3m, oxide region 124 encroaches laterally into oxide region 104 a distance (or width) $W_{OLG}$ from the place where right-hand edge 112 of oxide region 104 existed to a left-hand point 130 beyond which the thickness of oxide portion 104 is relatively constant. Oxide lateral growth distance $W_{OLG}$ may be measured empirically. In combination, oxide regions 104 and 124 form a composite insulation region having a maximum thickness at a point above P+ region 114 and a minimum thickness at a point above N region 66 with the thickness decreasing approximately from the vicinity of right-hand edge 120 to point 130.

The formation of oxide regions 124, 126, and 128 during the steam oxidation step causes the ends of nitride regions 84, 86, 88, and 90 not previously bent upward to bend upward as shown in Fig. 1m. Each of nitride regions 84, 86, 88, and 90 is now generally in the shape of an upright saucer as viewed from the side. The top surfaces of nitride regions 84, 86, 88, and 90 oxidize during the steam oxidation step to form electrically insulating coverings 132, 134, 136, and 138, respectively, of silicon dioxide having a thickness of approximately 20 nm (200 angstroms). The thickness of nitride regions 84, 86, 88, and 90 decreases slightly with the formation of oxide coverings 132, 134, 136, and 138.

A photoresist mask 140 is formed on the wafer as shown in Fig. 1n. Mask 140 has an open space extending from a point on the top surface of the left-hand section of oxide-isolation region 56 to a point near the middle of the top surface of insulation region 126, thereby covering the top surface of the wafer between the right-hand section of oxide region 56 and the middle of oxide region 126. Oxide coverings 132 and 134, which are exposed by this open space, are removed by etching with buffered hydrofluoric acid for 1 minute. This etching also decreases the thicknesses of the exposed portions of oxide regions 56, 124, and 126. Next, nitride regions 84 and 86 are removed by etching with boiling phosphoric acid for 45 minutes.

After removing mask 140, the silicon dioxide on the top surface of the wafer is etched with buffered hydrofluoric acid for 30 seconds to form open areas 142 and 144 as shown in Fig. 1o through oxide regions 104 and 106, respectively, thereby exposing sections of the upper surfaces of N region 66 and P− region 68, respectively. Oxide regions 124, 126 and 128 are also reduced in thickness. Preferably the top surface of the wafer is etched only for a time sufficient to remove oxide region 104 up to point 130 so that oxide region 124 has a well-defined left-hand edge at point 130 as shown in Fig. 3o. Alternatively, the top surface of the wafer may be etched rightward beyond point 130 but no closer than about 0.75—1.0 micron to left-hand boundary 120 of P+ region 114.

This etching removes oxide coverings 136 and 138 and further reduces the bird beak on oxide-isolation region 56. Nitride regions 88 and 90 protect oxide regions 108 and 110 from being etched by the buffered hydrofluoric acid.

A P-type dopant, boron from a $BBr_3$ source, is diffused at a temperature of 1,020°C into portions of N region 66 and P− region 68 exposed by open areas 142 and 144, respectively, to form P++ regions 146 and 148, respectively. Alternatively, boron first is either predeposited on the upper surfaces of regions 66 and 68 or ion implanted to a shallow depth in regions 66 and 68 and then is diffused to create P++ regions 146 and 148, respectively. P++ regions 146 and 148 are each approximately 300 nm (3,000 angstroms) in depth (or thickness) and have a sheet resistance of approximately 30 ohms/square. P++ region 146 extends laterally under the left-hand section of oxide-isolation region 56 and under oxide region 124.

The lateral diffusion of P++ region 146 under oxide region 124 is represented as a distance (or width) $W_{ELD}$ from edge 130 to the right-hand boundary 152 of P++ region 146 as shown in Fig. 3o. Since edge 130 is well defined, lateral diffusion distance $W_{ELD}$ for P++ region 146 is accurately controlled by controlling the diffusion conditions.

P++ region 146 is the emitter for a lateral PNP transistor. P+ region 114 is a collector for this lateral PNP transistor. N region 66 excluding both its portions now of P-type conductivity and its portions now oxidized is the base for the lateral transistor. The base widh $W_{BASE}$ of the lateral transistor is the minimum distance from left-hand boundary 120 of P+ region 114 to right-hand boundary 152 of P++ region 146.

Referring to Figs. 3l, 3m, and 3o, base width $W_{BASE}$ is given by

$$W_{BASE} = W_{ETBK} + W_{OLG} - W_{CLD} - W_{ELD} \qquad (4)$$

Oxide lateral growth distance $W_{OLG}$ and lateral diffusion distances $W_{CLD}$ and $W_{ELD}$ are functions of the heating/oxidation/diffusion conditions for creating oxide regions 124 and P+ region 114 and the diffusion conditions for creating P++ region 146. By holding these conditions constant, base width $W_{BASE}$ becomes a function of etchback distance $W_{ETBK}$ which, as indicated above, is substantially a linear function of etching time $t_{ET}$ at constant etchant temperature $T_{ET}$. Rate $R_{ET}$ at which distance $W_{ETBK}$ increases (ie., oxide region 104 is etched back) is given above as described for Fig. 4 or may be independently measured. Accordingly, base width $W_{BASE}$ is controlled accurately by varying etching time $t_{ET}$ and etchant temperature $T_{ET}$ as desired.

The top surface of the wafer is exposed at a temperature of 1,000°C to nitrogen and oxygen for 5 minutes, to steam for 20 minutes, and then to nitrogen for 5 minutes to grow electrically insulating region 154 of silicon dioxide between oxide regions 56 and 124 and to grow electrically insulating region 156 of silicon dioxide between oxide regions 124 and 126 as shown in Fig. 1p. The depth (or thickness) of oxide regions 154 and 156 is about 200 nm (2,000 angstroms).

The thickness of oxide regions 124, 126, and 128 increases during this heat treatment as some of the silicon forming the top surfaces of P+ regions 114, 116, and 118, respectively, is consumed (oxidized). Oxide-isolation region 56 increases slightly in thickness. Electrically insulating coverings 158 and 160 form from the top surfaces of nitride regions 88 and 90, respectively, as they decrease slightly in thickness. The depth (or thickness) of oxide coverings 158 and 160 is about 5 nm (50 angstroms).

During this heat treatment, the P-type impurity in P++ regions 146 and 148 moves (or is driven) further downward and sideward to create P++ regions 162 and 164, respectively. P++ regions 162 and 164 have a sheet resistance of about 70 ohms/square and are each approximately 500 nm (5,000 angstroms) in depth (or thickness). The P-type, impurity in P+ regions 114, 116, and 118 also diffuses slightly further downward and sideward.

The top surface of the wafer is exposed for 10 seconds to buffered hydrofluoric acid to remove oxide coverings 158 and 160 overlying nitride regions 88 and 90. The thickness of oxide regions 56, 124, 126, 128, 154, and 156 decrease slightly. Nitride regions 88 and 90 are then removed by exposing them to boiling phosphoric acid for 45 minutes.

A photoresist mask 170 is formed on the top surface of the wafer as illustrated in Fig. 1q. Mask 170 has an opening extending from the middle of oxide region 126 to a point on the right-hand section of oxide-isolation region 56. The surface area exposed by the opening in mask 170 is etched with buffered hydrofluoric acid for 1 minute to form open areas 172 and 174 through oxide regions 108 and 110, respectively, thereby exposing sections of the upper surfaces of P–

regions 68 and N region 70, respectively. This etching also reduces the thicknesses of the exposed portions of oxide regions 126, 128, and 56.

After removing mask 170, a photoresist mask 176 is formed on the top surface of the wafer as shown in Fig. 1r. Mask 176 has an opening extending approximately between the middles of oxide regions 124 and 128. A P-type impurity, boron in form of B+, is implanted through the opening in mask 170 (and through oxide region 156) into P– region 68 at an energy of 200 kiloelectron volts at a dosage of $5 \times 10^{12}$ ions/centimeter$^2$ to form P++ region 178 generally between oxide regions 124 and 126 and P+ region 180 generally between oxide regions 126 and 128. P++ region 178 includes within it original P++ region 164. P++ region 178 still has a sheet resistance of about 70 ohms/square while P+ region 180 has a sheet resistance of about 4500 ohms/square. Oxide regions 124, 126, and 128 generally prevent the P-type impurity from being implanted into P+ regions 114, 116, and 118, respectively. However, the P-type impurity penetrates sufficiently through the side portions of oxide regions 124, 126, and 128 such that P++ region 178 extends from P+ region 114 to P+ region 116 and P+ region 180 extends from P+ region 116 to P+ region 118. That is, regions 114, 178, 116, 180, and 118 form a continuous P-type low-resistivity region.

Alternatively, the etching and implant steps described in the two preceding paragraphs may be reversed.

After removing mask 176, an N-type impurity, phosphorus from a PBr₃ source, is diffused at a temperature of 960°C into portions of P+ region 180 and N region 70 exposed by openings 172 and 174, respectively, to form N+ regions 182 and 184, respectively, as shown in Fig. 1s. N+ regions 182 and 184 are each approximately 400 nm (4000 angstroms) in thickness and have a sheet resistance of about 25 ohms/square. Although this diffusion acts to repair lattice damage caused by the P-type implant used in forming P-type regions 178 and 180, a separate annealing step may be performed before or after this diffusion to enhance the repair of lattice damage.

N+ region 182 is the emitter for a vertical NPN transistor. P+ region 180 in combination with P– region 68, but excluding both N+ region 182 and the oxidized portions, is the base for this vertical transistor. N+ region 20 is a collector for the vertical NPN transistor.

While the emitter for the PNP lateral transistor originally comprised P++ region 146 as described above for Fig. 1o, P++ region 146 has expanded sideward and downward by diffusion to become P++ region 162 during subsequent high-temperature steps (and particularly during the step described for Fig. 1p). Similarly, P+ region 114 has expanded slightly sideward and downward during high-temperature steps subsequent to the step shown in Fig. 1o. As depicted in Fig. 1s, P++ region 162 now comprises the emitter for a lateral PNP transistor; slightly expanded P+ region 114 comprises the collector for this lateral transistor; N region 66 excluding both its portions now of P-type conductivity and its portions now oxidized comprises the base for the lateral transistor.

Base width $W_{BASE}$ for the lateral transistor of Fig. 1s is slightly different than that of the original lateral transistor illustrated in Fig. 1o. As shown in Figs. 3l and 3s, the lateral diffusion of P+ region 114 toward P++ region 162 is represented as distance $W_{CLD}'$ from original left-hand boundary 100 of P+ region 94 to the present left-hand boundary 186 of P+ region 114; the lateral diffusion of P++ region 162 under oxide region 124 is represented as a distance $W_{ELD}'$ from edge 130 to the right-hand boundary 188 of P++ region 162. Referring also to Fig. 3m, base width $W_{BASE}$ is now given by

$$W_{BASE} = W_{ETBK} + W_{OLG} - W_{CLD}' - W_{ELD}' \qquad (5)$$

The increase in diffusion distances $W_{CLD}'$ and $W_{ELD}'$ over diffusion distances $W_{CLD}$ and $W_{ELD}$, respectively, are functions of the diffusion conditions for the high-temperature steps subsequent to the step depicted in Fig. 1n. By holding these subsequent diffusion conditions constant, base width $W_{BASE}$ again becomes a function of etchback distance $W_{ETBK}$ and therefore substantially a linear function of etching time $t_{ET}$ at constant etchant temperature $T_{ET}$ for the present lateral transistor.

Electrical contacts are next formed on the wafer for the various components of the lateral and vertical transistors. A photoresist mask 190 having a pair of openings above P++ regions 162 and 178 is formed on the wafer as shown in Fig. 1t. Holes 192 and 194 are etched through oxide regions 154 and 156, respectively, down to P++ regions 162 and 178, respectively, by exposing oxide regions 154 and 156 through the openings in mask 190 to buffered hydrofluoric acid for a calculated etching time of at least 30 seconds. The etching time is determinable from experimental results and must not be great enough to expose any N-type conductivity part of N region 66. Alternatively, a mask with an opening extending from a point above the left-hand section of oxide-isolation region 56 to a point above oxide region 126 can be used in forming contact windows to P++ regions 162 and 178. In this case, the etching with buffered hydrofluoric acid also removes part of the exposed surfaces of oxide regions 56, 124, and 126 in addition to forming contact windows analogous to holes 192 and 194. When using this alternative, care must be exercised not to overetch and expose N region 66 at its surface.

After removing mask 190, an electrically conductive layer 196 of aluminum with about 2 percent silicon and 4 percent copper is deposited as shown in Fig. 1u on the top surface of the wafer and into openings 192, 194, 172, and 174 according to conventional techniques. The thickness of conductive layer 196 is about 700—800 nm (7,000—8,000 angstroms). The silicon in conductive layer 196 acts to prevent silicon diffusion into the aluminum and a corresponding penetration of the aluminum into the silicon (often termed "aluminum spiking") which would cause shorts at the emitter-base junctions of both the lateral and vertical transistors. The copper inhibits electron migration at high current densities. A photoresist mask 198 is formed on the top surface of conductive layer 196. Mask 198 has selected openings generally above one or more of oxide regions 56, 124, 126, and 128. The portions of conductive layer 196 exposed through mask 198 are removed according to conventional techniques.

The resulting structure is, for example, that, illustrated in Fig. 1v. The remaining portions of conductive layer 196 are regions 200, 202, 204, and 206 which make electrical contact with P++ regions 162 and 178 and N+ regions 182 and 184, respectively. Region 200 is the emitter contact for the lateral PNP transistor. Region 202 is the collector contact through P++ region 178 for the lateral transistor. Region 206 is the base contact through N-type regions 184, 70, and 20 for the lateral transistor. Likewise, for the vertical NPN transistor, region 204 is the emitter contact; region 206 is the collector contact through N-type regions 184 and 70; region 202 is the base contact through P-type regions 178 and 116 for the vertical transistor.

The impurities (both N-type and P-type) employed in forming the base for the lateral PNP transistor have been introduced into the wafer in a direction generally orthogonal to the plane of the wafer. The horizontal impurity variations for the $B^+$ implant to form P− region 28 (as shown in Fig. 1c) and the P++ implant to form N region 34 (as illustrated in Fig. 1d) are normally 2 percent or less. The horizontal impurity variation in the base of the lateral transistor is reduced substantially to zero during the subsequent high-temperature steps through lateral impurity diffusion. At the silicon/silicon-dioxide interface 208 between oxide region 124 and N region 66 as shown in Fig. 1v, some impurity does pile up during the growth of oxide region 124. Accordingly, except for the small impurity build up at interface 208, there is substantially no impurity variation in the narrow portion of N region 66 serving to define base width $W_{BASE}$ in a direction parallel to the plane of the wafer.

Furthermore, the vertical impurity variation in the base of the PNP lateral transistor is reduced to about $1 \times 10^{21}$ ions/centimeter$^4$ during the high-temperature steps when the impurities diffuse upward and downward to define N region 66. Consequently, the PNP base has very little impurity variation in any direction.

Referring again to Figs. 1j—1s, 3l, 3m, 3o and 3s, only a single masking edge 82 is utilized in defining emitter region 146 or 162 and collector region 114, and therefore base width $W_{BASE}$, for the lateral transistor. It is therefore self-aligning with masking edge 82.

Base width $W_{BASE}$ is controllable to 0.5 micron or less regardless of lithographic design rules. The amplification gain for the lateral transistor of the invention is typically 2—5 with a transit time less than 1 nanosecond.

Whereas the collector for the lateral PNP transistor has been described as comprising P+ region 114, the collector may be viewed as further including P++ region 178. Likewise, the base for the lateral transistor may be viewed as further including the N-type conductivity portions of region 20, or regions 20 and 70, or regions 20, 70, and 184. In some applications, the emitter and collector of the lateral transistor may be interchanged.

Similar considerations hold for the vertical NPN transistor. Its base may be viewed as further including various combinations of P-type regions 178, 116, and 118. Its collector may be viewed as further including the N-type conductivity portion of region 70 (including region 184). The emitter and collector for the vertical transistor may likewise be interchanged in some applications.

In lieu of doping a P-type layer (such as epitaxial layer 22) with an N-type impurity to create an N-type region (such as N region 34) which later becomes the base for the lateral PNP transistor and then introducing P-type impurities to define the emitter and collector, the lateral PNP transistor could alternatively be created by employing an N-type substrate or an N-type epitaxial layer which later becomes the base for a lateral PNP transistor and then following the steps illustrated for Figs. 1j—1o to define the emitter and collector. Furthermore, the steps described above may be utilized in forming other types of devices that have a three-region PNP configuration as in the lateral PNP transistor.

Semiconductor materials of the opposite conductivity type to those described above may be employed to accomplish the same results. That is, the foregoing steps may be followed in creating a lateral NPN transistor or other device having a corresponding three-region NPN configuration.

Other types of chemical etchants which substantially do not attack silicon and silicon nitride may be used in lieu of buffered hydrofluoric acid for etching silicon dioxide in one or more of the foregoing steps. Additionally, plasma etching techniques may alternatively be employed for most etching steps.

The invention has been described with reference to particular embodiments solely for the purpose of illustration. For example, other isolation techniques such as conventional planar techniques may be used in lieu of the isoplanar oxide-isolation techniques.

## Claims

1. A method for forming a pair of doped regions (114, 146) of a second conductivity type spaced apart from each other in a body of semiconductor material containing an impurity region (66) of a first conductivity type therein adjacent to an electrically insulating layer (50) along an upper surface of the body, wherein a protective layer (48) is deposited on the insulating layer, the method being characterized by the steps of:

forming an open space (74) through the protective layer above a first region in the body, which is intended for a first doped region of the pair of doped regions of the second conductivity type at a location which defines a right-hand edge (92) of the remainder (84) of the protective layer (48), renders at least a portion of the first region coincident with a portion of the impurity region, and allows a second region in the body, intended for a second doped region of the pair of doped regions of the second conductivity type, to be located laterally to the left of the first region, so that at least a portion of the second region may be coincident with a portion of the impurity region;

introducing a first semiconductor dopant of the second conductivity type through the open space (74) into the body in order to form a preliminary first doped region (94);

etching the insulating layer (50) through the open space (74) back under the remainder (84) of the protective layer for a selected lateral distance ($W_{ETBK}$) from the right-hand edge (92) leftward toward the second region (Fig. 3l);

diffusing the first dopant downward and sideward to form a completed first doped region (114) and simultaneously oxidizing along the upper surface adjacent portions of the preliminary first doped region (94) and of the impurity region (66) outside the first doped region to define an electrically insulating region (104, 124) including the insulating layer therein, thereby leaving the completed first doped region (114) in a form comprising the non-oxidized portion of the preliminary first doped region and having a left-hand boundary (120) projecting to the left from the right-hand edge (112) of the remainder (84) of the protective layer and the insulating region having a minimum thickness at a point above the second region (Fig. 3m);

removing at least a portion of the remainder (84) of the protective layer above the second region;

etching the insulating region (104, 124) for a sufficient time to form an open space (142) therethrough so as to define a left-hand edge (130) of the remainder (124) of the insulating region, the position of which edge is determinable by selecting the lateral distance ($W_{ETBK}$);

introducing a second semiconductor dopant of the second conductivity type through the open space (142) in the insulating region into the body to form the second doped region (146), so that the second doped region has a right-hand boundary (152) projecting to the right from the left-hand edge (130) of the remainder of the insulating region and spaced apart to the left of the left-hand boundary (120) of the completed first doped region (Fig. 3o).

2. A method as claimed in Claim 1 for manufacturing a transistor having a base, an emitter, and a collector, characterized in that the second conductivity type is opposite to the first conductivity type and that the emitter comprises one of the second doped region and the completed first doped region, and the collector comprises the other of the second doped region and the completed first doped region.

3. A method as claimed in Claim 2 characterized in that the step of forming the impurity region (66) comprises introducing a semiconductor impurity of the first conductivity type into the body at a direction generally orthogonal to a plane tangent to the upper surface to form the impurity region (Fig. 1d).

4. A method as claimed in Claim 3 characterized in that the step of forming the impurity region (66) further includes oxidizing a portion of the body along all of the upper surface to form the insulating layer (56, 50).

5. A method as claimed in Claim 2, 3 or 4 characterized in that the step of back etching includes etching the insulating layer (50) through the open space (74) down to semiconductor material of the body.

6. A method as claimed in any one of Claims 2 to 5 further characterized by including, before the step of introducing the first semiconductor dopant, a step of etching the insulating layer (50) through the open space down to semiconductor material of the body (Fig. 1k').

7. A method as claimed in any one of Claims 2 to 6 characterized in that the step of introducing the first semiconductor dopant comprises ion implanting the first dopant using the right-hand edge (92) of the remainder (84) of the protective layer to control the lateral extent of the preliminary first doped region (94) toward the second region, the remainder (84) of the protective layer substantially preventing the first dopant from being ion implanted elsewhere into the body.

8. A method as claimed in any one of Claims 2 to 7 characterized in that the remainder (84) of the protective layer substantially prevents the insulating layer (50) from being etched elsewhere during the step of etching.

9. A method as claimed in Claim 8 characterized in that the open space (74) in the protective layer (84, 86) is generally vertically aligned with and smaller in cross-section than the open space in the insulating layer (104, 106) (Fig. 1l).

10. A method as claimed in any one of Claims 2 to 9 characterized in that the step of oxidizing comprises exposing the adjacent portions of the preliminary first doped region (94) and of the impurity region (66) through the open space (74) to a selected oxidizing environment, the remainder (84) of the protective layer substantially preventing the remaining impurity region (66) from being oxidized.

11. A method as claimed in any one of Claims 2 to 10 characterized in that the step of removing comprises removing the entire remainder (84) of the protective layer (Fig. 1n).

12. A method as claimed in Claim 2, 5, 10 or 11, characterized in that the step of introducing the second semiconductor dopant comprises diffusing the second dopant into the second region using the left-hand edge (130) of the remainder (124) of the insulating region to control the lateral extent of the second doped region (146) toward the completed first doped region (114) (Fig. 1o).

13. A method as claimed in Claim 1, 5, 6, 7, 8 or 10 characterized in that the protective layer (48) is silicon nitride.

14. A method as in Claim 13 characterized in that the step of etching the insulating layer (50) is performed with a chemical etchant that substantially does not attack silicon nitride.

15. A method as in Claim 13 characterized in that the first dopant is singly ionized boron.

16. A method as in Claim 2, 5, 6, 7 or 10 characterized in that the first conductivity type is N type and the second conductivity type is P type.

17. A method as in Claim 2, 5, 6, 7 or 10 characterized in that the first conductivity type is P type and the second conductivity type is N type.

18. A lateral transistor formed in a body of semiconductor material comprising:
a first emitter/collector region (114) of a first conductivity type formed in the body and having a relatively flat first upper emitter/collector surface;
a second emitter/collector region (162) of the first conductivity type formed in the body laterally apart from the first emitter/collector region and having a relatively flat second upper emitter/ collector surface generally parallel to the first upper emitter/collector surface; and
a base region (66) of a second conductivity type opposite to the first conductivity type formed in the body, a portion of the base region lying directly between the emitter/collector regions characterised in that the second upper emitter/ collector surface is spaced vertically apart from the first upper emitter/collector surface, and that the portion of the base region lying directly between the emitter/collector regions has an upper base surface generally angled with respect to either upper emitter/collector surface, and that the base region has substantially a zero impurity variation in a direction generally parallel to either upper emitter/collector surface.

19. A transistor as claimed in Claim 18 characterized in that the base width, which constitutes the minimum distance separating the emitter/ collector regions within the portion, is less than or equal to 0.5 micron.

20. A transistor as claimed in Claim 18 or 19 characterized in that:
the body has a substantially flat lower surface generally parallel to the upper emitter/collector surfaces, the lower surface being closer to the first upper emitter/collector surface than the second upper emitter/collector surface; and
a region of electrically insulating material (124) is directly adjacent to all of the first upper emitter/collector surface and all of the upper base surface.

21. A transistor as in Claim 20 characterized in that the first emitter/collector region is an emitter and the second emitter/collector region is a collector.

## Patentansprüche

1. Ein Verfahren für die Bildung eines Paares dotierter Bereiches (114, 146) eines zweiten Leitfähigkeitstyps im Abstand voneinander in einem Korpus aus Halbleitermaterial, der einen Verunreinigungsbereich (66) eines ersten Leitfähigkeitstyps nahe einer· elektrisch isolierenden Schicht (50) längs einer oberen Oberfläche des Korpus aufweist, wobei eine Schutzschicht (48) auf der Isolierschicht abgelagert ist, welches Verfahren durch die Schritte gekennzeichnet ist:

Bildung eines offenen Raumes (74) durch die Schutzschicht oberhalb eines ersten Bereiches in dem Korpus, der für einen ersten dotieren Bereich des Paares dotierter Bereiche des zweiten Leitfähigkeitstyps an einer Stelle vorgesehen ist, die eine rechtsseitige Kante (92) des Restes (84) der Schutzschicht (48) definiert, mindestens einen Abschnitt des ersten Bereiches mit einem Abschnitt des Veruneinigungsbereiches koinzident macht und einem zweiten Bereich in dem Korpus, vorgesehen für einen zweiten dotierten Bereich des Paares dotierter Bereiche des zweiten Leitfähigkeitstyps, ermöglicht, seitlich nach links bezüglich ʿdes ersten Bereiches positioniert zu werden, so daß zumindest ein Abschnitt des zweiten Bereiches koinzident mit einem Abschnitt des Verunreinigungsbereiches sein kann;

Einführen eines ersten Halbleiterdotierungsmittels des zweiten Leitfähigkeitstyps durch den offenen Raum (74) in den Korpus, um einen vorläfigen ersten dotierten Bereich (94) zu bilden;

Ätzen der Isolierschicht (50) durch den offenen Raum (74) unterschneidend unter den Rest (84) der Schutzschicht für eine ausgewählte seitliche Distanz ($W_{ETBK}$) von der rechtsseitigen Kante (92) nach links in Richtung des zweiten Bereiches (Fig. 3l);

Diffundieren des ersten Dotierungsmittels abwärts und seitwärts zur Ausbildung eines vervollständigten ersten dotierten Bereiche (114) und gleichzeitiges Oxidieren längs der oberen Oberfläche nahe Abschnitten des vorläufigen ersten dotierten Bereiches (94) und des Verunreinigungsbereiches (66) außerhalb des ersten dotierten Bereiches zur Definition eines elektrisch isolierenden Bereiches (104, 124) einschließlich der Isolierschicht darin, wobei der vervollständigte erste dotierte Bereich (114) in einer Form verbleibt, umfassend den nichtoxidierten Abschnitt des vorläfigen ersten dotierten Bereiches und mit einer linksseitigen Begrenzung (120), die sich von der rechtsseitigen Kante (112) des Restes (84) der Schutzschicht nach links erstreckt, und wobei der isolierende Bereich eine Minimaldicke an einem Punkt oberhalb des zweiten Bereiches aufweist (Fig. 3m);

Abtragen mindestens eines Abschnitts des Restes (84) der Schutzschicht oberhalb des zweiten Bereiches;

Ätzen des isolierenden Bereiches (104, 124) für eine hinreichende Zeit zur Bildung eines offenen Raumes (142) dort hindurch, um so eine linksseitige Kante (130) des Restes (124) des isolierenden Bereiches zu definieren, wobei die Position dieser Kante bestimmbar ist durch Auswählen der seitlichen Distanz ($W_{ETBK}$);

Einführen eines zweiten Halbleiterdotierungsmittels des zweiten Leitfähigkeitstyps durch den offenen Raum (142) in dem isolierenden Bereich in dem Korpus zur Bildung des zweiten dotierten Bereiches (146) derart, daß der zweite dotierte Bereiche eine rechtsseitige Begrenzung (152) aufweist, die sich von der linksseitigen Kante (130) des Restes des isolierenden Bereiches nach rechts erstreckt und nach links im Abstand ist von der linksseitigen Begrenzung (120) des vervollständigten ersten dotierten Bereiches (Fig. 3o);

2. Ein Verfahren nach Anspruch 1 für die Herstellung eines Transistors mit einer Basis, einem Emitter und einem Kollektor, dadurch gekennzeichnet, daß der zweite Leitfähigkeitstyps dem ersten Leitfähigkeitstyp entgegengesetzt ist, und daß der Emitter einen der Bereiche von dem zweiten dotierten Bereich und dem vervollständigten ersten dotierten Bereich umfaßt, und daß der Kollektor den anderen dieser Bereiche umfaßt.

3. Ein Verfahren nach Anspruch 2, dadurch gekennzeichnet, daß der Schritt der Bildung des Verunreinigungsbereiches (66) das Einführen einer Halbleiterverunreinigung des ersten Leitfähigkeitstyps in den·Korpus bei einer Richtung umfaßt, die im wesentlichen senkrecht zu einer Ebene ist, tangential zur oberen Oberfläche zur Bildung des Verunreinigungsbereiches· (Fig. 1d).

4. Ein Verfahren nach Anspruch 3, dadurch gekennzeichnet, daß der Schritt der Bildung des Verunreinigungsbereichs (66)˙ ferner das Oxidieren eines Abschnitts des Korpus längs der gesamten oberen Oberfläche zur Bildung der Isolierschicht (56, 60) einschließt.

5. Ein Verfahren nach Anspruch 2, 3 oder 4, dadurch gekennzeichnet, daß der Schritt des unterschnittenen Ätzens das Ätzen der Isolierschicht (50) durch den offenen Raum (74) nach unten zum Halbleitermaterial des Korpus einschließt.

6. Ein Verfahren nach einem der Ansprüche 2 bis 5, ferner gekennzeichnet durch Einschluß, vor dem Schritt des Einführens des ersten Halbleiterdotierungsmittels, eines Schrittes des Ätzens der Isolierschicht (50) durch den offenen Raum nach unten zum Halbleitermaterial des Korpus (Fig. 1k').

7. Ein Verfahren nach einem der Ansprüche 2 bis 6, dadurch gekennzeichnet, daß der Schritt des Einführens des ersten Halbleiterdotierungsmittels das Ionenimplantieren des ersten Dotierungsmittels umfaßt unter Verwendung der rechtsseitigen Kante (92) des Restes (84) der Schutzschicht zum Steuern der seitlichen Ausdehnung des vorläufigen ersten dotierten Bereiches (94) in Richtung des zweiten Bereiches, wobei der Rest (84) der Schutzschicht im wesentlichen verhindert, daß das erste Dotierungsmittel irgendwo sonst in dem Korpus ionenimplantiert wird.

8. Ein Verfahren nach einem der Ansprüche 2 bis 7, dadurch gekennzeichnet, daß der Rest (84) der Schutzschicht im wesentlichen verhindert, daß die Isolierschicht (50) irgendwo sonst während des Ätzvorganges geätzt wird.

9. Ein Verfahren nach Anspruch 8, dadurch gekennzeichnet, daß der offene Raum (74) in der Schutzschicht (84, 86) im wesentlichen vertikal ausgefluchtet ist mit dem offenen Raum in der Isolierschicht (104, 106) und im Querschnitt kleiner ist als dieser (Fig. 1l).

10. Ein Verfahren nach einem der Ansprüche 2 bis 9, dadurch gekennzeichnet, daß der Schritt des Oxidierens das Aussetzen der banachbarten Abschnitte des vorläufigen ersten dotierten Bereiches (94) und des Verunreinigungsbereiches (66) durch den offenen Raum (74) zu einem ausgewählten oxidierenden Milieu umfaßt, wobei der Rest (84) der Schutzschicht im wesentlichen verhindert, daß der restliche Verunreinigungsbereich (66) oxidiert wird.

11. Ein Verfahren nach einem der Ansprüche 2 bis 10, dadurch gekennzeichnet, daß der Schritt des Abtragens den Abtrag des gesamten Restes (84) der Schutzschicht umfaßt.(Fig. 1n).

12. Ein Verfahren nach Ansprüchen 2, 5, 10 oder 11, daß der Schritt des Einführens des zweiten Halbleiterdotierungsmittels das Diffundieren des zweiten Dotierungsmittels in den zweiten Bereich umfaßt unter Verwendung der linksseitigen Kante (130) des Restes (124) des Isolierbereiches zum Steuern der seitlichen Ausdehnung des zweiten dotierten Bereiches (146) in Richtung des vervollständigten dotierten ersten Bereiches (114) (Fig. 1o).

13. Ein Verfahren nach Ansprüche 1, 5, 6, 7, 8 oder 10, dadurch gekennzeichnet, daß die Schutzschicht (48) Siliciumnitrid ist.

14. Ein Verfahren nach Anspruch 13, dadurch gekennzeichnet, daß der Schritt des Ätzens der Isolierschicht (50) mit einem chemischen Ätzmittel durchgeführt wird, das Siliciumnitrid im wesentlichen nicht angreift.

15. Ein Verfahren nach Anspruch 13, dadurch gekennzeichnet, daß das erste Dotierungsmittel ausschließlich ionisiertes Bor ist.

16. Ein Verfahren nach Anspruch 2, 5, 6, 7 oder 10, dadurch gekennzeichnet, daß der erste Leitfähigkeitstyp N-Leitfähigkeit ist und der zweite Leitfähigkeitstyp P-Lietfähigkeit.

17. Verfahren nach Anspruch 2, 5, 6, 7 oder 10, dadurch gekennzeichnet, daß der erste Leitfähigkeitstyp P-Leitfähigkeit ist und der zweite Leitfähigkeitstyp N-Leitfähigkeit ist.

18. Ein Lateraltransistor, gebildet in einem Korpus von Halbleitermaterial, umfassend:
einen ersten Emitter/Kollektor-Bereich (114) eines ersten Leitfähigkeitstyps, gebildet von dem Korpus mit einer relativ flachen ersten oberen Emitter/Kollektor - Oberfläche,
einen zweiten Emitter/Kollektor - Bereich (162) des ersten Leitfähigkeitstyps, gebildet in dem Korpus seitlich getrennt von dem ersten Emitter/ Kollektor - Bereich und mit einer relativ flachen zweiten oberen Emitter/Kollektor - Oberfläche, die im wesentlichen parallel zu der ersten oberen Emitter/Kollektor - Fläche verläuft, und
einen Basisbereich (66) eines zweiten Leitfähigkeitstyps, entgegengesetzt dem des ersten Leitfähigkeitstyp, ausgebildet in dem Korpus, wobei ein Abschnitt des Basisbereichs direkt zwischen den Emitter/Kollektor - Bereichen liegt, dadurch gekennzeichnet, daß die zweite obere Emitter/ Kollektor-Fläche vertikal im Abstand von der ersten oberen Emitter/Kollektor-Fläche liegt, und daß der Abschnitt des Basisbereichs, der direkt zwischen den Emitter/Kollektor - Bereichen liegt, eine obere Basisfläche hat, die generell unter einem Winkel bezüglich jeder der oberen Emitter/ Kollektor - Flächen steht, und daß der Basisbereich eine im wesentlichen bei Null liegende Verunreinigungsvariation in einer Richtung im wesentlichen parallel zu jeder der oberen Emitter/ Kollektor-Flächen aufweist.

19. Ein Transistor nach Anspruch 18, dadurch gekennzeichnet, daß die Basisbreite, welche den Minimalabstand bildet, der die Emitter/Kollektor - Bereiche innerhalb des Abschnitts trennt, kleiner oder gleich 0,5 Micron ist.

20. Ein Transistor nach Anspruch 18 oder 19, dadurch gekennzeichnet, daß der Korpus eine im wesentlichen flache untere Fläche aufweist, generell parallel zu den oberen Emitter/ Kollektor - Flächen, wobei die untere Fläche näher der ersten oberen Emitter/Kollektor - Fläche liegt als der zweiten oberen Emitter/ Kollektor - Fläche, und daß ein Bereich elektrisch isolierenden Materials (124) direkt nahe allen ersten oberen Emitter/Kollektor - Flächen und der gesamten oberen Basisfläche ist.

21. Ein Transistor nach Anspruch 20, dadurch gekennzeichnet, daß der erste Emitter/Kollektor - Bereich ein Emitter und der zweite Emitter/ Kollektor - Bereich ein Kollektor sind.

**Revendications**

1. Procédé pour former une paire de régions dopées (114, 116) d'un deuxième type de conductivité, espacées. l'une de l'autre dans un bloc de matériau semi-conducteur contenant une région d'impureté (66) d'un premier type de conductivité adjacente à une couche électriquement isolante (50) le long d'une surface supérieure du bloc, dans lequel on dépose une couche protectrice (48) sur la couche isolante, le procédé étant caractérisé par les étapes suivantes:
former une ouverture (74) au travers de la couche protectrice au-dessus d'une première région du bloc, destinée à devenir une première région dopée de la paire de régions dopées du deuxième type de conductivité à un emplacement qui définit un bord droit (92) sur le reste (84) de la couche protectrice (48), qui fait coincide au moins une partie de la première région avec une partie de la région d'impureté, et permet à une deuxième région du bloc, destinée à devenir une deuxième région dopée de la paire de régions dopées du deuxième type de conductivité, d'être située latéralement à gauche de la première région, de façon qu'au moins une partie de la deuxième région coïncide avec une partie de la région d'impureté;

introduire un premier dopant de semi-conducteur du deuxième type de conductivité au travers de l'ouverture (74) dans le bloc, afin de former une première région dopée préliminaire (94);

attaquer la couche isolante (50) au travers de l'ouverture (74) jusqu'au reste (84) de la couche protectrice sur une distance latérale sélectionnée ($W_{ETBK}$) depuis le bord droit (92) vers la gauche vers la deuxième région (figure 3l);

diffuser le premier dopant vers la bas et sur le côté pour former une première région terminée (114) et oxyder simultanément, le long de la surface supérieure, des parties adjacentes de la première région dopée préliminaire (94) et de la région d'impureté (66) à l'extérieur de la première région dopée pour définir une région électriquement isolante (104, 124) incluant la couche isolante, de façon à laisser la première région dopée terminée (114) sous une forme comprenant la partie non oxydée de la première région dopée préliminaire et ayant une frontière gauche (120) dépassant vers la gauche du bord droit (112) du reste (84) de la couche protectrice et la région isolante ayant une épaisseur minimale et un point situé au-dessus de la deuxième région (figure 3m);

enlever au moins une partie du reste (84) de la couche protectrice au-dessus de la deuxième région;

attaquer la région isolante (104, 124) pendant un temps suffisant pour former une ouverture (142) au travers de cette région de façon à définir un bord gauche (130) sur le reste (124) de la région isolante, la position de ce bord pouvant être déterminée en sélectionnant la distance latérale ($W_{ETBK}$);

introduire un deuxième dopant de semi-conducteur du deuxième type de conductivité au travers de l'ouverture (142) de la région isolante dans le bloc pour former la deuxième région dopée (146), de façon que la deuxième région dopée ait, à droite, une frontière (152) dépassant vers la droite du bord gauche (130) du reste de la région isolante et espacée vers la gauche de la frontière gauche (120) de la première région dopée terminée (figure 3o).

2. Procédé selon la revendication 1 pour la fabrication d'un transistor ayant une base, un émetteur et un collecteur, caractérisé en ce que la deuxième type de conductivité est opposé au premier type de conductivité et en ce que l'émetteur est soit la deuxième région dopée, soit la première région dopée terminée, le collecteur étant formé par l'autre de ces deux régions.

3. Procédé selon la revendication 2, caractérisé en ce que l'étape de formation de la région d'impureté (66) comprend l'étape consistant à introduire une impureté de semi-conducteur du premier type de conductivité dans le bloc avec une direction généralement orthogonale à un plan tangent à la surface supérieure pour former la région d'impureté (figure 1d).

4. Procédé selon la revendication 3, caractérisé en ce que l'étape de formation de la région d'impureté (66) comprend de plus l'opération consistant à oxyder une partie du bloc le long de toute sa surface supérieure pour former la couche isolante (56, 50).

5. Procédé selon la revendication 2, 3 ou 4, caractérisé en ce que l'étape d'attaque de la couche isolante consiste à attaquer la couche isolante (50) au travers de l'ouverture (74) jusqu'au matériau semi-conducteur du bloc.

6. Procédé selon l'une des revendications 2 à 5, caractérisé de plus en ce qu'il comprend, avant l'étape d'introduction du premier dopant de semi-conducteur, une étape consistant à attaquer la couche isolante (50) au travers de l'ouverture jusqu'au matériau semi-conducteur du bloc (figure 1k').

7. Procédé selon l'une des revendications 2 à 6, caractérisé en ce que l'étape d'introduction du premier dopant de semi-conducteur comprend l'opération consistant à implanter le premier dopant en utilisant le bord droit (92) du reste (84) de la couche protectrice pour contrôler la dimension latérale de la première région dopée préliminaire (94) vers la deuxième région, le reste (84) de la couche protectrice empêchant sensiblement le premier dopant d'être implanté sous forme d'ions dans d'autres parties du bloc.

8. Procédé selon l'une des revendications 2 à 7, caractérisé en ce que le reste (84) de la couche protectrice empêche sensiblement la couche isolante (50) d'être attaquée ailleurs pendant l'étape d'attaque.

9. Procédé selon la revendication 8, caractérisé en ce que l'ouverture (74) de la couche protectrice (84, 86) est généralement verticalement alignée avec l'ouverture de la couche isolante (104, 106) et de section plus faible (figure 1l).

10. Procédé selon l'une des revendications 2 à 9, caractérisé en ce que l'étape d'oxydation consiste à exposer les parties adjacentes à la première région dopée préliminaire (94) et à la région d'impureté (66) au travers de l'ouverture (74) à un environnement oxydant sélectionné, le reste (84) de la couche protectrice empêchant sensiblement la région d'impureté restante (66) d'être oxydée.

11. Procédé selon l'une des revendications 2 à 10, caractérisé en ce que l'étape d'enlèvement consiste à enlever tout le reste (84) de la couche protectrice (figure 1n).

12. Procédé selon la revendication 2, 5, 10 ou 11, caractérisé en ce que l'étape d'introduction du deuxième dopant de semi-conducteur consiste à

**0 065 463**

diffuser le deuxième dopant dans la deuxième région en utilisant le bord gauche (130) du reste (124) de la région isolante pour contrôler la dimension latérale de la deuxième région dopée (146) vers la première région dopée terminée (114) (figure 1o).

13. Procédé selon la revendication 1, 5, 6, 7, 8 ou 10, caractérisé en ce que la couche protectrice (48) est en nitrure de silicium.

14. Procédé selon la revendication 13, caractérisé en ce que l'étape d'attaque de la couche isolante (50) est effectuée au moyen d'un produit chimique qui n'attaque sensiblement pas le nitrure de silicium.

15. Procédé selon la revendication 13, caractérisé en ce que le premier dopant est du bore ionisé à une seule charge.

16. Procédé selon la revendication 2, 5, 6, 7 ou 10, caractérisé en ce que le premier type de conductivité est le type N et le deuxième type de conductivité est le type P.

17. Procédé selon la revendication 2, 5, 6, 7 ou 10, caractérisé en ce que le premier type de conductivité est le type P et le deuxième type de conductivité est le type N.

18. Transistor latéral formé dans un bloc de matériau semi-conducteur comprenant:

une première région d'émetteur/collecteur (114) d'un premier type de conductivité formée dans le bloc et ayant une première surface supérieure d'émetteur/collecteur relativement plate;

une deuxième région d'émetteur/collecteur (162) du premier type de conductivité formée dans le bloc à une certaine distance latérale de la première région d'émetteur/collecteur et ayant une deuxième surface supérieure d'émetteur/collecteur généralement parallèle à la première surface supérieure d'émetteur/collecteur; et

une région de base (66) d'un deuxième type de conductivité opposé au premier type de conductivité, formée dans le bloc, une partie de la région de base étant située directement entre les régions d'émetteur/collecteur, caractérisée en ce que la deuxième surface supérieure d'émetteur/collecteur est distante verticalement de la première surface supérieure d'émetteur/collecteur, et en ce que la partie de la région de base située directement entre les régions d'émetteur/collecteur a une surface supérieure de base formant généralement un angle par rapport à l'une ou l'autre des surfaces supérieures d'émetteur/collecteur, et en ce que la région de base a sensiblement une variation nulle en impureté dans une direction généralement parallèle à l'une ou l'autre des surfaces supérieures d'émetteur/collecteur.

19. Transistor selon la revendication 18, caractérisé en ce que la largeur de base qui constitue la distance minimale qui sépare les régions d'émetteur/collecteur dans la partie est inférieure ou égale à 0,5 micron.

20. Transistor selon la revendication 18 ou 19, caractérisé en ce que:

le bloc a une surface inférieure sensiblement plate généralement parallèle aux surfaces supérieures d'émetteur/collecteur, la surface inférieure étant plus proche de la première surface supérieure d'émetteur/collecteur que la deuxième surface supérieure d'émetteur/collecteur; et

une région de matériau électriquement isolant (124) est directement adjacente à toute la première surface supérieure d'émetteur/collecteur et à toute la surface supérieure de base.

21. Transistor selon la revendication 20, caractérisé en ce que la première région d'émetteur/collecteur est un émetteur et la deuxième région d'émetteur/collecteur est un collecteur.

FIG. 1a

FIG. 1b

FIG. 1c

FIG. 1d

FIG. 1e

1

FIG. If

FIG. Ig

FIG. Ih

FIG. Ii

# 0 065 463

**FIG. 1j**

**FIG. 1k**

**FIG. 1k'**

**FIG. 1ℓ**

3

0 065 463

FIG. Im

FIG. In

FIG. Io

FIG. Ip

4

**0 065 463**

**FIG. 1q**

**FIG. 1r**

**FIG. 1s**

**FIG. 1t**

5

FIG. 1u

FIG. 1v

FIG. 2a

IMPLANT PROJECTED DEPTH $R_{PSi}$ AND STANDARD DEVIATION $\Delta R_{PSi}$ ($nm$)

$R_{PSi}$

$\Delta R_{PSi}$

ION IMPLANT ENERGY $E_I$ (KILOELECTRON VOLTS)

FIG. 2c

FIG. 2b

0 065 463

FIG. 3ℓ

FIG. 3m

FIG. 3o

FIG. 3s

8

FIG. 4